(19) Europäisches Patentamt
European Patent Office
Office européen des brevets

(11) **EP 2 908 397 B1**

(12) **EUROPÄISCHE PATENTSCHRIFT**

(45) Veröffentlichungstag und Bekanntmachung des Hinweises auf die Patenterteilung:
**09.08.2017   Patentblatt 2017/32**

(51) Int Cl.:
*H02H 3/40* (2006.01)        *H02H 3/46* (2006.01)
*G01R 19/00* (2006.01)        *G01R 27/08* (2006.01)
*G01R 27/16* (2006.01)        *H02H 1/00* (2006.01)

(21) Anmeldenummer: **14000533.1**

(22) Anmeldetag: **14.02.2014**

(54) **Verfahren zum Schutz eines elektrischen Versorgungsnetzes**

Method for protecting an electrical supply network

Procédé de protection d'un réseau d'alimentation électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.08.2015   Patentblatt 2015/34**

(73) Patentinhaber: **NSE AG**
**5610 Wohlen (CH)**

(72) Erfinder: **Fromm, Wilhelm**
**8280 Kreuzlingen (CH)**

(74) Vertreter: **Schalch, Rainer**
**c/o E. Blum & Co. Patentanwälte**
**Vorderberg 11**
**CH-8044 Zürich (CH)**

(56) Entgegenhaltungen:
**EP-A1- 2 487 766      EP-A2- 1 237 249**
**US-A- 4 455 612**

**Beschreibung**

Gebiet der Erfindung

Die Erfindung betrifft ein Verfahren zum Schutz eines elektrischen Versorgungsnetzes, eine entsprechende Vorrichtung zum Schutz des Versorgungsnetzes und ein Computerprogramm gemäss den jeweiligen unabhängigen Ansprüchen.

Hintergrund

Schutz-, Mess- und Steuersysteme für mit Wechselspannung betriebene Elektroenergienetze sind bekannt. Sie werten meistens die Signalkomponenten bei einer Nennfrequenz $f_N$, z.B. 50 Hz oder 60 Hz, aus. Diese Systeme sollen insbesondere Kurzschlüsse in einem Versorgungsnetz erfassen. Zu diesem Zweck werden in Mittel- und Hochspannungsnetzen beispielsweise Distanzschutzgeräte oder Überstromschutzgeräte eingesetzt. Im Fehlerfall, also z.B. Kurzschluss oder Erdschluss, wird der dazugehörige Leistungsschalter ausgeschaltet und somit das fehlerhafte Netzsegment vom restlichen Versorgungsnetz getrennt.

Naheliegend ist die Auswertung der Signale mit einer Netzfrequenz $f \approx f_N$, weil sie von der Einspeisung erzeugt werden und normalerweise relativ stark ausgeprägt sind, im Gegensatz zu anderen Frequenzanteilen, die häufig nur in bestimmten Störungsfällen und oft auch nur transient auftreten.

Typischerweise werden also die nennfrequenten Ströme und Spannungen gemessen, woraus sich die entsprechenden komplexen Zeiger ermitteln lassen. Mit den komplexen Spannungs- und Stromzeigern lässt sich der Impedanz-Zeiger bestimmen, der für den Distanzschutz verwendet wird.

Beim Distanzschutz wird der Impedanz-Zeiger ausgewertet. Im Falle entsprechender digitaler Schutzrelais ist es möglich, den Realteil und den Imaginärteil des Impedanz-Zeigers getrennt zu erfassen, wodurch Einflüsse von Lasten auf das Auslöseverhalten des Schutzes berücksichtigt werden können. Im Falle eines Kurzschlusses auf einer Leitung des Hoch- oder Mittelspannungsnetzes erhöht sich auf der betroffenen Leitung der Stromfluss und die Spannung fällt ab. Dies entspricht einer Verringerung der Impedanz, deren Wert als Mass für die Auslösung des Schutzes verwendet wird. Einem Impedanzbereich ist eine Auslösezeit zugeordnet, so dass mehrere gestaffelte Auslösezeiten vorliegen. Dadurch ist es möglich, die Abschaltung des betroffenen Leitungsabschnitts in Abhängigkeit von der Entfernung des Fehlers (Kurzschluss, Erdschluss) anzupassen, wobei auch die Richtung des Fehlers (vor der Messstelle oder hinter der Messstelle) erkennbar ist. So werden beispielsweise Fehler, die nahe an der Messstelle liegen, schneller abgeschaltet als weit entfernte Stellen. Dabei ist bei nahen Fehlern die ermittelte Impedanz vergleichsweise gering ist (die Impedanz hängt im Wesentlichen von dem Stück Leitung bis zum Fehler ab). Durch den Einsatz mehrerer Distanzschutzeinrichtungen ist es möglich, für jeden Fehlerort eine schnelle Abschaltung zu ermöglichen, indem die jeweils nächste Distanzschutzeinrichtung verwendet wird. Gelingt keine Abschaltung, so kann eine weiter entfernte Distanzschutzeinrichtung gemäss einer entsprechend längeren Auslösezeit (höhere Impedanz) eingreifen, was als Reserveschutz bezeichnet wird.

Offensichtlich ist eine schnelle Abschaltung eines Fehlers erwünscht, um Beschädigungen von Netzkomponenten auf ein Minimum zu reduzieren. Ein weiteres massgebliches Kriterium für eine solche Schutzvorrichtung ist eine gute Selektivität, mit anderen Worten die Genauigkeit der Fehlererkennung. Je genauer die Vorrichtung arbeitet desto besser lassen sich Überfunktionen, d.h. eine Identifizierung eines Fehlers wenn keiner vorliegt, vermeiden.

Der Standard IEC 60255-121 definiert Richtlinien zur Evaluierung der Qualität von Distanzschutzeinrichtungen. Diese Richtlinien spiegeln sich in eine Reihe von Testszenarien mit variierten Parametern. Als Beispiel für solche Parameter sei der SIR-Wert genannt, der eine Klassifizierung der Leitungslänge beschreibt und im Standard IEC 60255.121 definiert ist.

Ein für die Qualität der Distanzschutzvorrichtung besonders wichtiger Test ist in Kap. 6.3.2 und 6.3.4 des Standards beschrieben und zielt auf die Dynamik der zu testenden Vorrichtung hinsichtlich typischer Reaktionszeit und dem "transient overreach". Dieser Test adressiert eines der Probleme beim Design von Distanzschutzvorrichtungen: das DC-Offset des Stroms im Fehlerfall. Ein Fehlerstrom hat normalerweise einen DC-Offset- oder Gleichstromanteil zusätzlich zur nennfrequenten Wechselstromkomponente. Da der Gleichstromanteil mit der Zeit abklingt, hängt das Verhältnis der beiden Stromkomponenten vom Zeitpunkt ab, in dem der Fehler in der Leitung stattgefunden hat. Die Abklingrate des Gleichstromanteils hängt ihrerseits von der Impedanz der Leitung ab. Der Gleichstromanteil kann die Evaluierung eines Fehlers beeinflussen und bewirken dass der Distanzschutz in manchen Konstellationen versagt.

Eine Evaluierung von vorhandenen Lösungen für Distanzschutzvorrichtungen im Sinne des erwähnten Tests wurde von Boris Bastigkeit und Andreas Biermath durchgeführt (Boris Bastigkeit, Andreas Biermath: Evaluation of Distance Protection Performance According to the Proposed Standard IEC 60255-121. International Protection Testing Symposium (IPTS) 2010, Salzburg, Austria). Der Test hat gezeigt, dass die erhältlichen Distanzschutzvorrichtungen entweder eine hohe Genauigkeit jedoch eine langsame Reaktionszeit, oder umgekehrt, aufweisen.

Darstellung der Erfindung

Aufgabe der Erfindung ist daher die Verbesserung bestehender Lösungen im Bereich der Fehlererkennung in Stromversorgungsnetzen hinsichtlich Genauigkeit und Reaktionszeit.

Diese Aufgabe wird mit einem Verfahren nach Anspruch 1 gelöst. Demgemäss wird ein Verfahren zum Schutz eines elektrischen Versorgungsnetzes bei einem Fehler vorgeschlagen, das die folgenden Schritte umfasst:

a) Messen mindestens eines elektrischen zeitperiodischen Signals des Versorgungsnetzes,

b) Bestimmen von Realteilen und Imaginärteilen der ersten und der zweiten Harmonischen durch Transformation des zeitperiodischen Signals in den Frequenzbereich,

c) Bilden modifizierter Filterkoeffizienten mindestens für einen modifizierten Imaginärteil des transformierten zeitperiodischen Signals durch Kombination von Imaginärteil-Filterkoeffizienten der ersten und der zweiten Harmonischen, wobei die Imaginärteil-Filterkoeffizienten der ersten und der zweiten Harmonischen derart zur Bildung der modifizierten Koeffizienten kombiniert werden, dass die Imaginärteil-Filterkoeffizienten der zweiten Harmonischen mit einem Faktor multipliziert und anschliessend von den Imaginärteil-Filterkoeffizienten der ersten Harmonischen subtrahiert werden, anschliessend entweder

d1) Überprüfen für jeden Abtastwert ob der modifizierte Imaginärteil das gleiche Vorzeichen wie der Imaginärteil der ersten Harmonischen hat und ob der Betrag des modifizierten Imaginärteils grösser als der Betrag des Imaginärteils der ersten Harmonischen ist,

e1) Setzen eines Ausgang-Imaginärteils gleich dem modifizierten Imaginärteil wenn die Bedingungen aus Schritt d1) erfüllt sind, oder Setzen des Ausgang-Imaginärteils gleich dem Imaginärteil der ersten Harmonischen wenn die Bedingungen aus Schritt d1) nicht erfüllt sind,

f1) Bestimmen einer Leitungsimpedanz ($Z_L$) mit Hilfe des Ausgangs-Imaginärteils,

oder

d2) Bestimmen einer ersten Impedanz unter Verwendung der ersten Harmonischen,

e2) Bestimmen einer zweiten Impedanz unter Verwendung des modifizierten Imaginärteils,

f2) Auswahl als Leitungsimpedanz der betragskleineren Impedanz aus der ersten und der zweiten Impedanz oder der Impedanz mit einem betragskleineren Imaginärteil aus der ersten und der zweiten Impedanz,

und anschliessend

g) Vergleichen der Leitungsimpedanz mit mindestens einem vorgegebenen Wert, und

h) Ausgeben eines Steuersignals für eine Unterbrechungskomponente des Versorgungsnetzes falls die Leitungsimpedanz kleiner als der mindestens eine vorgegebene Wert ist.

Vorzugsweise wird ein Leitungsstrom oder eine Leitungsspannung des Versorgungsnetzes als elektrisches zeitperiodisches Signal gemessen. Es ist aber auch möglich zwei elektrische zeitperiodische Signale, ein Leitungsstrom und eine Leitungsspannung des Versorgungsnetzwerks zu messen und beide als Grundlage des erfindungsgemässen Verfahrens zu verwenden. Das oder die elektrischen zeitperiodischen Signale wird bzw. werden vorzugsweise bei Nennfrequenz des Versorgungsnetzes ausgewertet.

Vorzugsweise gehört der betrachtete Fehler des Versorgungsnetzes einer der Fehlertypen: Kurzschluss, Erdschluss, Überstrom.

In einer weiteren Ausführungsform wird die Überprüfung für jeden Abtastwert, ob der modifizierte Imaginärteil das gleiche Vorzeichen wie der Imaginärteil der ersten Harmonischen hat und ob der Betrag des modifizierten Imaginärteils grösser als der Betrag des Imaginärteils der ersten Harmonischen ist, mit einer einstellbaren Zeitverzögerung durchgeführt.

In einer weiteren Ausführungsform wird der Schritt h) sofort nach Schritt g) oder zeitverzögert durchgeführt.

Alternativ zum Vergleich mit mindestens einem vorgegebenen Wert kann der Vergleich aus Schritt g) mit einem Satz oder mehreren Sätzen vorgegebener Werte durchgeführt werden. Dies hat den Vorteil dass mehrere Impedanzbereich untersucht werden können, so dass die Schutzmassnahme als Sofort- oder Reservemassnahme eingestuft werden kann (vgl. oben).

Ferner wird die Aufgabe mittels einer entsprechenden Schutzvorrichtung nach dem unabhängigen Vorrichtungsanspruch 11 gelöst.

Schliesslich wird die Aufgabe mittels eines Computerprogramms gelöst, das aus einem Satz von Anweisungen zur Implementierung des erfindungsgemässen Verfahrens besteht. Das Computerprogramm ist insbesondere mittels einer erfindungsgemässen Schutzvorrichtung ausführbar.

Die erfindungsgemässe Schutzvorrichtung wird vorzugsweise zum Distanzschutz oder Überstromschutz von elektrischen Versorgungsnetzen verwendet.

Die Vorteile des erfindungsgemässen Verfahrens und Vorrichtung sind die Bereitstellung einer Mess-, Auswerte- und Steuermöglichkeit mit einer schnellen Reaktionszeit und genauen Ergebnissen. Dabei kann zwischen den zwei alternativen Berechnungsmöglichkeiten gewählt werden. Basierend auf die Bildung eines modifizierten Imaginärteils des transformierten zeitperiodischen Signals kann entweder zunächst eine Auswahl des geeigneten Imaginärteils des transformierten zeitperiodischen Signals erfolgen und auf dieser Basis eine Ausgangsimpedanz berechnet werden, oder es können zunächst zwei Ausgangsimpedanzen berechnet werden und aus diesen die geeignete Auswahl getroffen werden. Beide Alternativen führen zu ähnlichen Ergebnissen und verbessern ein elektrisches Versorgungsnetz im Hinblick auf einen effizienteren Schutz gegen Kurzschlüsse, Erdschlüsse, etc..

Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:

Fig. 1 eine stark vereinfachte Struktur eines Stromversorgungsnetzes,
Fig. 2 ein Blockbild der Signalverarbeitung einer erfindungsgemässen Schutzvorrichtung,
Fig. 3 ein beispielhaftes Impedanzdiagramm für eine Leitung einer bestimmten Länge,
Fig. 4 Diagramme mit Koeffizienten verwendeter Digitalfilter für die Ermittlung eines nennfrequenten Signalanteils (links), zugehörige Amplitudenfrequenzgänge (Mitte) und gefilterte Exponentialglieder (rechts),
Fig. 5 Effektivwerte eines Kurzschlussstroms auf Basis der ersten und der zweiten Harmonischen (oben) und resultierende Fehler für die erste Harmonische durch abklingenden Gleichstromanteil (unten),
Fig. 6 eine Trajektorie einer ermittelten Impedanz nach dem Stand der Technik, und
Fig. 7 eine Trajektorie einer ermittelten Impedanz gemäss der Erfindung.

Wege zur Ausführung der Erfindung

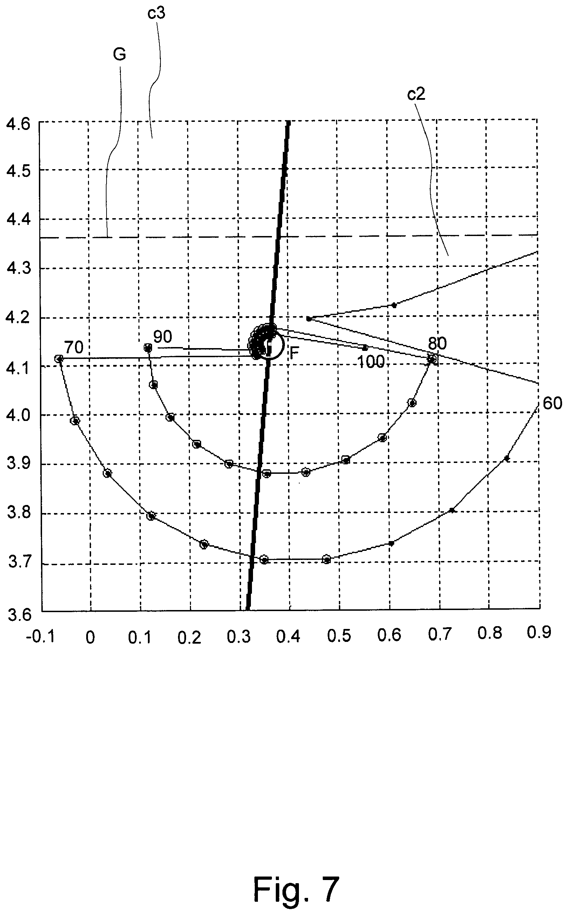

Im Folgenden wird die erste Berechnungsalternative näher erläutert. Die zweite Alternative, d.h. die Ermittlung zweier Impedanzen und daraus die Auswahl der geeigneten Impedanz, wird in Zusammenhang mit Fig. 7 nur kurz umrissen, da sie auch auf die Berechnungen im Zusammenhang mit der zeitperiodischen Grösse basiert.

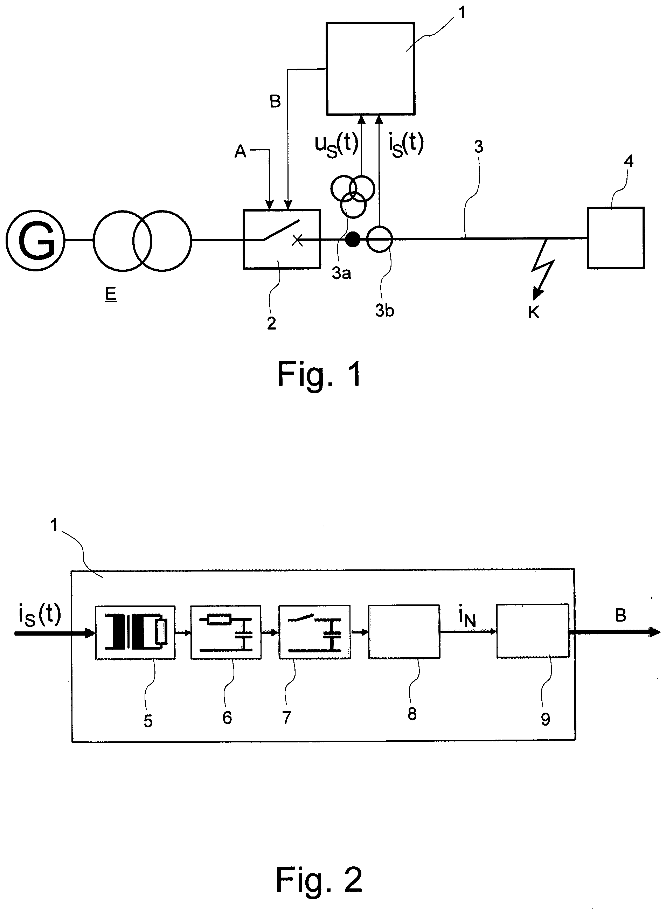

Fig. 1 zeigt eine stark vereinfachte Struktur eines mit Wechselspannung betriebenen Energieversorgungsnetzes mit einer Schutz-, Mess- und Steuervorrichtung 1. Die erfindungsgemässe Schutz-, Mess- und Steuervorrichtung 1, im Folgenden Schutzvorrichtung 1 genannt, wertet mindestens eine nennfrequente Signalkomponente (Strom, Spannung) des Netzes aus.

Für die nachfolgenden Überlegungen wird von einer Netzfrequenz von $f_N = 50$ Hz ausgegangen. Andere Netzfrequenzen, insbesondere $f_N = 60$ Hz, können aber auch verwendet werden. Ferner werden die Überlegungen aus Vereinfachungsgründen nur für die Stromberechnung durchgeführt.

Auf der Primärseite E betreibt ein Generator G über eine Stromquelle das Netz, das hier mit einer exemplarischen Leitung 3 und einen daran angeschlossenen Verbraucher 4 dargestellt ist. In der Leitung ist ein Leistungsschalter 2 zwischengeschaltet, der zur Unterbrechung bzw. Aufnahme der elektrischen Versorgung der Leitung 3 dient. Derartige Leistungsschalter sind bekannt und werden daher hier nicht näher erläutert. Der Leistungsschalter 2 besitzt Mittel zum Empfangen eines Einschaltbefehls A um das Versorgungsnetz an die Primärseite E anzuschliessen und zum Empfangen eines Ausschaltbefehls B. Der Ausschaltbefehl B wird von der Schutzvorrichtung 1 ausgegeben, falls ein Fehler in der Leitung 3, z.B. ein Kurzschluss oder ein Erdschluss K, stattgefunden hat. Zur Erkennung des Fehlers K verwendet die Schutzvorrichtung 1 die von einem Hauptwandler des Versorgungsnetzes in Form von Sekundärgrössen $u_s(t)$ und $i_s(t)$ bereitgestellten Leitungsspannung u(t) und Leitungsstrom i(t) der Leitung 3. Auf Basis dieser Messung bestimmt die Schutzvorrichtung 1 die nennfrequenten Signalanteile und daraus die Impedanz der Leitung 3. Diese Berechnungen dienen für eine Entscheidung der Schutzvorrichtung ob ein Fehler K vorliegt oder nicht und werden im weiteren Verlauf der Beschreibung näher erläutert. Im Falle des Vorliegens eines Fehlers K schickt die Schutzvorrichtung 1 den Ausschaltbefehl B an den Leistungsschalter 2, um die betroffene Leitung oder den betroffenen Leitungsabschnitt vom Netz abzukoppeln.

Fig. 2 zeigt ein Blockbild der erfindungsgemässen Schutzvorrichtung 1 mit den Stationen der Signalverarbeitung am Beispiel der Sekundärgrösse Strom. Der Leitungsstrom $i_s(t)$ wird in einen Eingangswandler 5 eingespeist, durchläuft einen Anti-Aliasing Filter 6 zur Dämpfung hoher Frequenzanteile und wird anschliessend über ein Abtast-Halte-Glied 7 mittels eines Analog/Digital-Wandlers 8 in Digitalwerte iN kodiert. Die derart vorbereiteten diskreten Stromwerte $i_N$ werden einem Signalprozessor 9 zur weiteren Signalverarbeitung zugeführt. Der Signalprozessor 9 gibt schliesslich ein Steuersignal B (Ausschaltbefehl) für den Leistungsschalter 2 aus, falls er einen Fehler K festgestellt hat. Der Signalprozessor wird vorzugsweise dazu verwendet, das erfindungsgemässe Computerprogramm auszuführen und alle zur Ermittlung der Impedanz gemäss dem erfindungsgemässen Verfahren notwendigen Berechnungen durchzuführen.

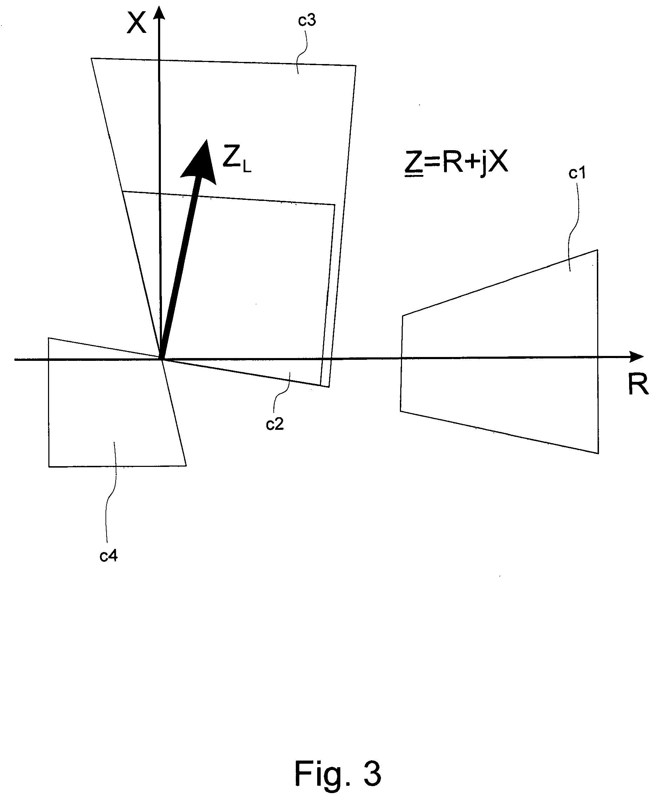

Fig. 3 zeigt ein beispielhaftes Impedanzdiagramm für die Leitung 3 mit der Impedanz $Z_L$. Der Impedanzvektor (dargestellt mit dem Pfeil) ergibt sich in bekannter Weise aus dem Realteil R und dem Imaginärteil X mit $Z = R + jX$. Im Diagramm sind die typischen Bereiche von Impedanzen dargestellt, die in bestimmten Betriebs- bzw. Fehlerfällen auftreten können. Der Bereich c1 ist typisch für die Impedanz des Verbrauchers 4 bei Wirkleistung in Richtung der Leitung. Der Bereich c2 stellt ein Auslösegebiet erster Stufe dar; wenn sich die ermittelte Impedanz $Z_L$ in diesem Bereich befindet wird ein Ausschaltsignal B an den Leistungsschalter 2 geschickt. Dieses Gebiet berücksichtigt Fehler, die in der Nähe der Messstelle der Schutzvorrichtung 1 stattgefunden haben und von dieser schnell abgeschaltet werden können. Der Bereich c3 stellt ein Auslösegebiet für Fehler dar, die sich weiter entfernt von der Messstelle der Schutzvorrichtung 1 befinden und ist als Reserveschutz anzusehen wenn eine Schutzvorrichtung, die dem Fehler näher ist, keine Ausschaltung durchführen kann. Schliesslich stellt der Bereich c4 einen Fehler in Rückwärtsrichtung dar.

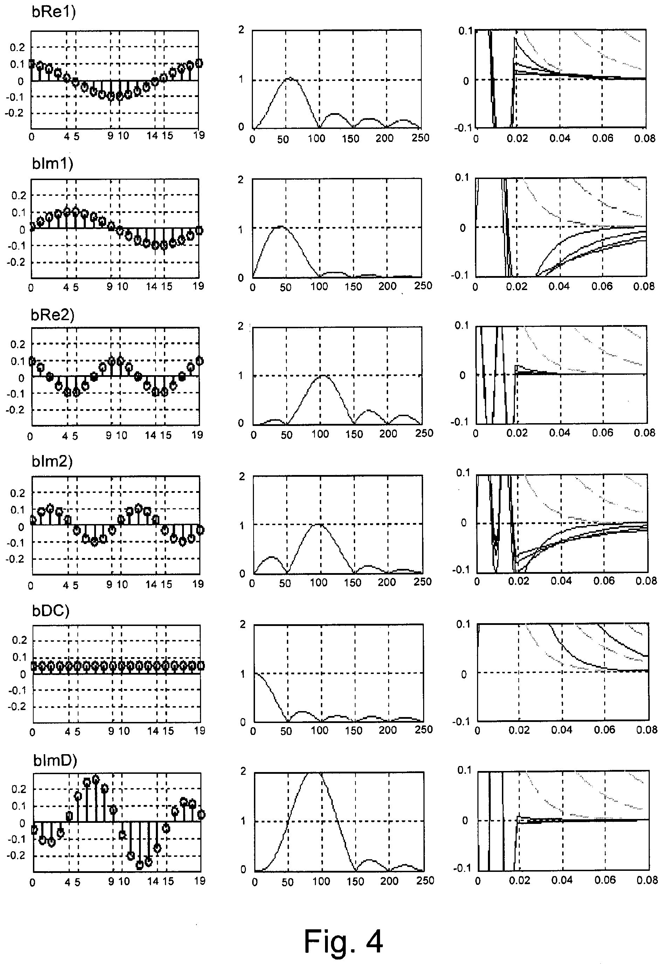

Fig. 4 zeigt in der linken Spalte Diagramme mit Werten von Koeffizienten verwendeter Digitalfilter als Funktion diskreter Zeitpunkte für die Ermittlung des nennfrequenten Signalanteils des Stroms. In der mittleren Spalte sind die zugehörigen Amplitudenfrequenzgänge dargestellt (normiert auf den Betrag bei der Frequenz, die das jeweilige Filter vor allem auswerten soll, also 50 Hz, 100 Hz oder 0 Hz), und in der rechten Spalte entsprechend die gefilterten Exponentialglieder. Die Diagramme jeder Zeile gehören zusammen.

Die erste und die zweite Zeile entsprechend dem Stand der Technik während die Zeilen 3 bis 6 Diagramme gemäss der Erfindung darstellen. Als nächstes werden die Hintergründe der gezeigten Koeffizienten beschrieben.

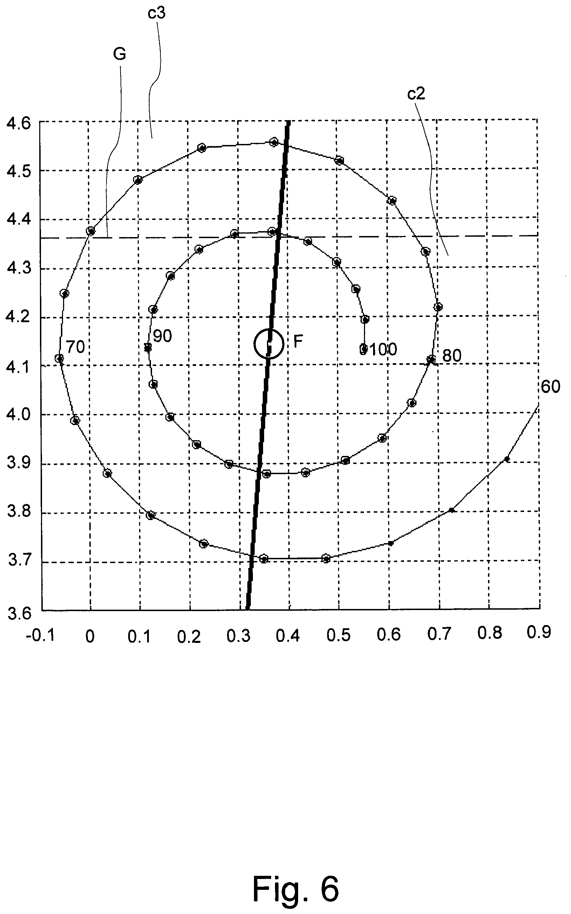

Es ist bekannt die Zeigergrössen eines periodischen, zeitkontinuierlichen Signals mittels Fourier-Transformation zu ermitteln, wodurch sich die Amplitude und der Phasenwinkel berechnen lassen. Mittels der komplexen Grössen für Strom und Spannung lässt sich beispielsweise die Impedanz $Z_L$ aus Fig. 2 berechnen, worauf im Zusammenhang mit Fig. 6 und 7 näher eingegangen wird.

Die komplexen Zeigergrössen können auch digital bestimmt werden, was ebenfalls bekannt ist, wobei die praktische Realisierung als numerisches Fourier-Filter bezeichnet wird. Dazu geht die Fourier-Transformation in die diskrete Fourier-Transformation über, d.h. die Integration wird durch eine Summenbildung ersetzt. Die Summanden zu jedem Abtastzeitpunkt $n \cdot \Delta t$ ergeben sich aus dem Produkt vom Abtastwert i(t) und Gewichtsfaktoren $b_{Re,k}$ bzw. $b_{Im, k}$, die bei der praktischen Realisierung als Filterkoeffizienten bezeichnet werden und, wie erwähnt, in der linken Spalte von Fig. 4 dargestellt sind. Ein solcher Filter ist durch die folgenden Summen charakterisiert:

$$Re\{I\} = \sum_{k=0}^{p} b_{Re,k} \cdot i_{n-k}$$

$$Im\{I\} = \sum_{k=0}^{p} b_{Im,k} \cdot i_{n-k}$$

Dabei bezeichnen Re{I} und Im{I} den Realteil bzw. den Imaginärteil des komplexen Stromzeigers I und p die Anzahl der Abtastungen pro Periode. Die Gewichtsfaktoren $b_{Re,k}$ und $b_{Im, k}$ sind konstante Werte die den sin- bzw. cos-Werten der Zeitfunktion zum Zeitpunkt $k \cdot \Delta t$ entsprechen. In diesem Dokument werden die Filterkoeffizienten grundsätzlich indirekt durch die Bezeichnungen I1, I1D, I1A ausgedrückt, die dem linken Teil der obigen Gleichungen entsprechen bzw. durch Vergleiche von komplexen Stromgrössen entstehen. Ferner beziehen sich die obigen Bezeichnungen auf die Imaginärteile der jeweiligen Grösse sofern nicht anders angegeben.

Die beispielhaften Betrachtungen der digitalen Signalverarbeitung basieren auf einer Abtastrate von 1 kHz, d.h. p=20 (20 Abtastungen/Periode).

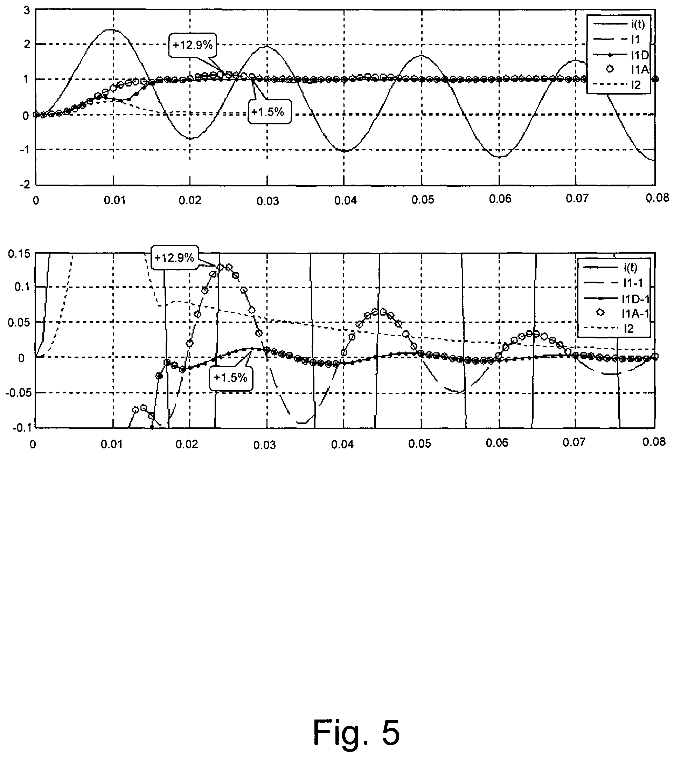

Fig. 5 zeigt Effektivwerte eines Kurzschlussstroms auf Basis der ersten und der zweiten Harmonischen (oben) und resultierende Fehler für die erste Harmonische durch den abklingenden Gleichstromanteil (unten) als Funktion der Zeit in Sekunden. In beiden Diagrammen bezeichnen:

- i(t) den gemessenen zeitperiodischen Leitungsstrom,
- I1 die erste Harmonische des zeitperiodischen Leitungsstroms,
- I1D den Verlauf der ersten Harmonischen mit modifizierten Filterkoeffizienten,
- I1A den Verlauf der ersten Harmonischen nach der Überprüfung gemäss Schritt d1) des erfindungsgemässen Verfahrens, und
- I2 die zweite Harmonische des zeitperiodischen Leitungsstroms.

Wie aus Bild 5 ersichtlich reduziert sich der betragsgrösste Fehler schon durch die erste Verbesserungsmassnahme mit I1D (modifizierte Filterkoeffizienten durch Kombination der Filterkoeffizienten der ersten und der zweiten Harmonischen) von zirka 12.9% auf zirka 1.5%. Wie erwähnt sind die Ergebnisse auf der Basis einer Netzfrequenz von 50Hz dargestellt, jedoch sind vergleichbare Genauigkeitsverbesserungen auch bei anderen Netzfrequenzen vorhanden.

Die Auswertung nach dem Stand der Technik durch die Verwendung eines Fourier-Filters für die erste Harmonische hat den Nachteil, dass sie bei abklingenden Gleichstromanteilen einen beträchtlichen Fehler hervorruft. Für eine schnelle Fehlererkennung ist sie deshalb nicht zuverlässig genug, da, wie aus Fig. 5 (oben) ersichtlich (vgl. Amplitudenverlauf des Kurzschlussstroms i(t), z.B. bis zirka 0.03s), der abklingende Gleichstromanteil unmittelbar nach Auftreten des Kurzschlusses den grössten Einfluss auf den Verlauf des Kurzschlussstroms hat. Folglich (vgl. auch die Ergebnisse der Evaluierung aus dem im Kapitel "Hintergrund" genannten Dokument) leidet die Genauigkeit bei schnellen Auswertungen gemäss diesem bekannten Verfahren. Wie weiter aus Fig. 5 ersichtlich nimmt der Einfluss des abklingenden Gleichstromanteils mit der Zeit immer mehr ab (vgl. den Amplitudenverlauf ab 0.03s) so dass die Auswertung gemäss dem bekannten Verfahren immer genauer wird. Das Ergebnis (es wird wieder auch auf das zitierte Dokument verwiesen) sind genaue Messungen aber eine lange Reaktionszeit. Zusammenfassend kann gesagt werden, dass eine schnell reagierende Schutzvorrichtung nach dem Stand der Technik von gelegentlichen Über- bzw. Unterfunktionen geprägt ist, während eine genau auswertende bekannte Vorrichtung den Fehler erst spät beheben kann, wobei die Auswirkungen dieser Nachteile für jede dieser zwei Alternativen bereits erwähnt wurden.

Im Gegensatz dazu kann eine entsprechende Filterung mit I1D (modifizierte Filterkoeffizienten) den Fehler deutlich reduzieren, wie oben erwähnt. Die modifizierten Filterkoeffizienten werden mindestens für einen modifizierten Imaginärteil des transformierten zeitperiodischen Signals durch Kombination von Imaginärteil-Filterkoeffizienten der ersten und der zweiten Harmonischen gebildet. Vorzugsweise besteht die Kombination darin, dass die Imaginärteil-Filterkoeffizienten der zweiten Harmonischen mit einem Faktor multipliziert werden und anschliessend von den Imaginärteil-Filterkoeffizienten der ersten Harmonischen subtrahiert werden. Der Faktor wird so gewählt, dass der Einfluss der zweiten Harmonischen soweit gewünscht eliminiert wird. Für die in Fig. 4 gezeigte Filterdimensionierung ergibt sich bei vollständiger Elimination ein Faktor von 2. Sinnvolle Faktoren liegen also im Bereich von 0 bis 2, je nachdem, wie stark der Anteil der zweiten Harmonischen eliminiert werden soll. Vorzugsweise beträgt der Faktor 1.9.

Eine weitere Verbesserung, insbesondere hinsichtlich der Empfindlichkeit bei höherfrequenten Störungen, bei verschiedenen Ausgleichsvorgängen sowie bei Frequenzabweichungen vom Nennwert, wird durch einen Vergleich der Werte des Imaginärteils I1 der ersten Harmonischen mit den ermittelten Werten mit I1D gemäss den modifizierten Filterkoeffizienten erreicht. Bei einer solchen adaptiven Filterung mit I1A wird angestrebt dass einerseits kein kleinerer Messwert als der grössere von I1 und I1D vorliegt, so dass Unterfunktionen weitgehend vermieden werden, und andererseits dass kein größerer Messwert als I1 oder I1D vorliegt, so dass keine größere Überfunktion als ohne die adaptive Filterung auftreten kann. Mit anderen Worten soll die Messung im Zweifelsfall zum größeren Stromwert hin tendieren. Die Messung eines zu großen Stromwertes soll nicht länger als eine halbe Periode (bei Nennfrequenz) bestehen.

Dazu wird ein adaptives Filter angewendet, das zu jedem Abtastzeitpunkt folgendermaßen funktioniert:

Wenn I1D das gleiche Vorzeichen wie I1 hat und betragsgrößer als I1 ist, wird als Ausgangswert I1A = I1D gewählt.

In allen anderen Fällen wird I1A = I1 gesetzt. Dabei entspricht I1A dem oben genannten Ausgangs-Imaginärteil.

Die Ergebnisse der adaptiven Filterung mit I1A sind ebenfalls in Fig. 5 dargestellt: es treten nie kleinere Werte als I1D auf sondern nur teilweise größere bzw. zu große. Die zu großen Werte treten allerdings nur relativ kurz auf, nämlich längstens ein halbe Periode der Grundschwingung (10 ms), so dass deren Einfluss durch eine definierbare Zeitverzögerung ausgeglichen werden kann. Diese einstellbare Zeitverzögerung wird folglich kleiner oder gleich einer halben Periode einer Grundschwingung des elektrischen zeitperiodischen Signals oder der elektrischen zeitperiodischen Signale gewählt. Vorzugsweise beträgt sie bei der hier angenommenen Nennfrequenz 10 ms.

Die obigen Ergebnisse sind als Zwischenergebnisse anzusehen, um aus den Strom- und Spannungswerten die Leitungsimpedanz zu errechnen, welche letztendlich als Kriterium für den Distanzschutz dient. Die Bestimmung der Impedanz wird im Folgenden erläutert.

Fig. 6 zeigt eine Trajektorie einer ermittelten Impedanz für den Distanzschutz nach dem Stand der Technik. Beim Distanzschutz ist der Ort eines Fehlers von Bedeutung (z.B. Kurzschluss), mit anderen Worten die Distanz vom Messpunkt der Distanzschutzvorrichtung zum Fehler. Wie oben erläutert ermöglicht die Ermittlung des Ortes die beste Abschaltstrategie des betroffenen Leitungsbereichs. Wie erwähnt kann die Impedanz als Z = U/I ermittelt werden. Dabei wurde anhand des Stromes oben beschrieben, wie die Ermittlung der komplexen Grössen anhand der Berechnung der ersten Harmonischen erfolgt. Ein daraus resultierendes Diagramm gemäss dem allgemeinen Beispiel aus Fig. 3 ist in Fig. 6 dargestellt. In diesem Beispiel wird der Distanzschutz in einem direkt geerdeten Hochspannungsnetz untersucht. Bei dieser Art von Kurzschluss muss der Erdimpedanzfaktor berücksichtigt werden, was bekannt ist und daher nicht näher erläutert wird. Auf einer Stichleitung tritt bei t = 40 ms ein Erdkurzschluss L1 auf, der von dieser erster Distanzschutzvorrichtung durch Abschalten der Leitung geklärt werden soll. Die erste Distanzschutzzone erfasst 80 Prozent der zu schützenden Leitung, und der Fehlerort ist bei 95 Prozent des zu schützenden Bereichs, also relativ nah an der Stufengrenze. Als Stufengrenze wird die Grenze zwischen zwei Impedanzbereichen bezeichnet (vgl. Fig. 3 und die zugehörige Beschreibung). Ein Fehler nah an der Stufengrenze wurde hier deshalb als Beispiel gewählt, da es in diesem Bereich besonders auf Messgenauigkeit ankommt. Ergibt die Untersuchung der Impedanz dass der Fehler im Bereich c2 angesiedelt ist (vgl. Fig. 3), so würde dies einer sofortigen Abschaltung durch die erste Distanzschutzvorrichtung entsprechen. Befindet sich der Fehler hingegen im Bereich c3, so würde die erste Distanzschutzvorrichtung nur eine Abschaltung mit Verzögerung durchführen, falls die Abschaltung nicht durch eine weitere Distanzschutzvorrichtung (bei der die von ihr gemessene Impedanz in ihrem eigenen Bereich c2 liegt) vorgenommen worden ist.

In Fig. 6 wurde die Grenze zwischen der ersten und der zweiten Impedanzzone c2, c3 (entsprechend den Bereichen in Fig. 3) mit G bezeichnet. Die mit einem kleinen Kreis umrandeten Impedanzpunkte werden vom Distanzschutz tatsächlich ausgewertet, nachdem die Anregung für die Leitung nach einer kleinen Zeitverzögerung angesprochen hat. Der Fehlerort ist in Fig. 6 auf der Impedanzlinie mit vom Kreis F hervorgehoben. Man erkennt dass der Schutz zunächst keinen stabilen Auslösebefehl erteilen kann, da die Messung nicht stabil im Bereich der ersten Impedanzzone c2 liegt. Da ein mittels der Distanzschutzvorrichtung zu steuernder Leistungsschalter selbst eine Zeit, z.B. 50 ms, bis zur Unterbrechung des Stromes benötigt, kann eine Abschaltung nicht mehr im geforderten Zeitbereich durchgeführt werden. Im Idealfall gäbe es 20 ms nach Fehlerbeginn einen stabilen Messpunkt entsprechend der Kurzschlussimpedanz. Vor Kurzschlussbeginn würde die Impedanz etwa der Lastimpedanz (z.B. in der Größenordnung 100 Ohm) entsprechen, während in den 20 ms nach Fehlereintritt ein Übergang zur Kurzschlussimpedanz beobachtbar ist. In der hier gezeigten Trajektorie wird jeder Abtastwert (im Zeitraster 1 ms) mit einem Punkt gekennzeichnet, und alle 10 ms wird die Zeit in ms beim Punkt ergänzt.

Wie aus der Trajektorie ersichtlich ist die Ursache für die verzögerte Auslösung der spiralförmige Verlauf des komplexen Impedanzzeigers ($Z_L$ aus Fig. 3), so dass der Zeiger das Auslösegebiet c2 mehrfach wieder verlässt. Der spiralförmige Verlauf wiederum kommt vom Einfluss des abklingenden Gleichstromanteils auf die Filterkomponente Im{I1}. Auch wenn der beschriebene Distanzschutz nach dem Stand der Technik in vielen typischen Fällen tadellos arbeitet, so ist es wünschenswert dass eine Distanzschutzvorrichtung auch kritische Fälle wie den Fehler nahe an der Stufengrenze mit dem entsprechenden Fehlereintrittswinkel usw. ohne Überfunktion und ohne Unterfunktion beherrscht.

Der Lösungsansatz ist, wie beschrieben, eine verbesserte Filterung auf der Basis von I1D und I1A einzusetzen, wodurch eine akkurate und schnelle Berechnung der Impedanz möglich ist. Die Ergebnisse im Hinblick auf die Impedanzmessung auf Basis des Konzepts gemäss der vorliegenden Erfindung werden nachfolgend erläutert.

Fig. 7 zeigt eine Trajektorie einer ermittelten Impedanz gemäss dem Auswahlverfahren aus Schritt d1) (I1A) der ersten Berechnungsalternative.

Wie aus der Figur zu erkennen ist, sind die gemessenen Impedanzen immer im Bereich c2 und übersteigen nie die Bereichsgrenze G. Damit ist eine zuverlässige und schnelle Identifizierung des Fehlers (hier Erdschluss) möglich. Das Verfahren unter Verwendung der adaptiven Imaginärteil-Filterung I1A liefert also ein stabiles Auslösekriterium und gleichzeitig "gleichmäßige" Impedanzverläufe.

Eine weitere Verbesserung, insbesondere im Hinblick auf die Minimierung von Überfunktionen, ist dadurch gegeben, dass die Auslösebedingung mindestens während einer halben Periode (ca. 10 ms) erfüllt sein muss, bevor die Distanzschutzvorrichtung einen entsprechenden Abschaltbefehl ausgibt. Dadurch sind keine Überfunktionen mehr zu erwarten, da der ursächliche Anteil der 2. Harmonischen alle 10 ms zu einer entgegengesetzten Tendenz führt und damit wieder der "stabile" 11-Anteil bestimmend ist.

Im Falle der zweiten Berechnungsalternative ergeben sich jeweils eine Trajektorie wie in Fig. 7 für jede der zwei ermittelten Impedanzen Z1, Z2. Der Unterschied zwischen der ersten und der zweiten Alternative liegt darin, dass bei der ersten Alternative zunächst zwei Imaginärteile des gemessenen transformierten zeitperiodischen Signals berechnet werden und auf dieser Basis eine Impedanz ermittelt wird, während bei der zweiten Alternative zunächst zwei Impedanzen aus den Imaginärteilen des zeitperiodischen Signals ermittelt werden und daraus eine geeignete gewählt wird. Bei der zweiten Alternative erfolgt die Impedanzbestimmung mit I1 und I1D und ergibt die erste bzw. die zweite Impedanz Z1, Z2. Für eine Auslösung des Befehls B kann dann aus den zwei Impedanzen Z1, Z2 die für die Überprüfung der Leitung zugrunde zu legende Impedanz folgendermaßen abgeleitet beziehungsweise ausgewählt werden:

- Auswahl der betragskleineren Impedanz. Die Ergebnisse gleichen erwartungsgemäss der Auswertung mit der ersten Alternative mit I1A (entsprechend der Beziehung Z=U/I mit Auswertung der Beträge).
- Auswahl der Impedanz mit dem betragskleineren Imaginärteil (X-Anteil).

Die Beispiele zeigen, dass die Auswahlmethoden häufig zu ähnlichen Resultaten führen. Je nach Netzverhältnissen können aber auch deutlichere Unterschiede auftreten, z.B. abhängig vom R/X-Verhältnis der zu schützenden Leitung.

Bei der zweiten Alternative ergeben sich ähnliche Trajektorien wie in Fig. 7, wobei natürlich die Werte je nach Verwendung der betragskleineren Impedanz oder der Impedanz mit dem betragskleineren Imaginärteil variieren.

Die Anwendung der Fourierfilterung unter Verwendung des adaptiven I1A-Algorithmus oder Z1/Z2-Algorithmus liefert immer stabile Auslösungen und vermeidet gleichzeitig Überfunktionen, wenn man eine interne Verzögerung des Auslösebefehls von einer halben Periode der Netzfrequenz berücksichtigt. Das gilt nicht nur für die gezeigten Beispiele, sondern auch für anderen Fälle mit unterschiedlichen Netzkonfigurationen, Fehlerarten, Lastbedingungen etc.

Die maximal zu erwartenden Auslösezeiten (Ansprechzeiten) lassen sich mit Berücksichtigung folgender Anteile abschätzen:

Antialiasingfilter und sonstige Laufzeiten bei den Spannungs- und Stromsignalen im Bereich der Analog-Digital-Umsetzung: Typischerweise kleiner oder ungefähr gleich 1 ms (fast vernachlässigbar);
Einschwingdauer der Fourierfilterung bzw. der adaptiven Fourierfilter (I1, I1A): 20 ms;
Verzögerung zur sicheren Vermeidung von Überfunktionen: 10 ms;
Weitere Verzögerungen (z.B. interne Zeitverzögerungen, Einschwingen der Spannungssignale, Rechenzeiten bzw. Software-Laufzeiten): z.B. 3 ms;
Ansprechzeiten der Ausgangssignale bis zur Leistungsschalteransteuerung, z.B. durch Relaiskontakte: z.B. 10 ms; sehr abhängig von der Hardware-Realisierung und hier daher ausgeklammert.

Damit können also maximale Distanzschutz-Auslösezeiten von ca. 34 ms erwartet werden (unter Vernachlässigung der Auslösekreise). Insbesondere für Fehler direkt an der Stufengrenze ist dies in Kombination mit der sicheren Vermeidung von Überfunktionen ein sehr guter Wert.

Eine Bewertung im Vergleich zu anderen Distanzschutzalgorithmen ermöglichen Messungen bzw. Simulationen entsprechend den in der IEC-Norm 60255-121 definierten dynamischen Distanzschutz-Prüfungen. Im der am Anfang zitierten Evaluierung des Prüfsystemherstellers Omicron werden die Messungen mit mehreren Relais unterschiedlicher Hersteller verglichen. Bei allen Relais schwanken die Ansprechzeiten relativ stark (min. 15 ms, zum Teil weit mehr als 20 ms). Außerdem sind weitere Nachteile der untersuchten Relais ersichtlich: beim Relais (A) sind die längsten Ansprechzeiten größer als 60 ms und bei den anderen Relais (B und C) gibt es an den Stufengrenzen Über- oder Unterfunktionen (indirekt dokumentiert in den SIR-Diagrammen).

Das erfindungsgemässe Verfahren und die erfindungsgemässe Vorrichtung können mit Vorteil nicht nur zur Realisierung eines effektiven Distanzschutzes, sondern auch für den Überstromschutz verwendet werden, bei dem eine (relativ kleine) Unterfunktion durch abklingenden Gleichstrom vermieden werden muss. Das Verfahren kann auch bei einem Unterstromschutz entsprechend verwendet werden: der betragskleinere Wert von I1 und I1D wird immer weiterverarbeitet. Damit wäre sichergestellt, dass der Unterstromschutz nicht ungewollt zurückfällt.

Eine entsprechende Auswertung des Imaginärteils mit I1A oder Z1/Z2 für die Spannungen wäre ebenfalls denkbar. Im elektrischen Energieversorgungsnetz sind aber Fälle mit exponentiell abklingenden Gleichspannungsanteilen eher selten und unkritisch. Bei der Impedanzbestimmung wird deswegen die Filterung mit I1A lediglich auf die Ströme angewendet.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

**Patentansprüche**

1. Verfahren zum Schutz eines elektrischen Versorgungsnetzes bei einem Fehler (K) umfassend die Schritte:

   a) Messen mindestens eines elektrischen zeitperiodischen Signals (i(t)) des Versorgungsnetzes,

   b) Bestimmen von Realteilen und Imaginärteilen (Re{I1}, Im{I1}; Re{I2}, Im{I2}) der ersten und der zweiten Harmonischen (I1, I2) durch Transformation des zeitperiodischen Signals (i(t)) in den Frequenzbereich,

   c) Bilden modifizierter Filterkoeffizienten mindestens für einen modifizierten Imaginärteil (I1D) des transformierten zeitperiodischen Signals (i(t)) durch Kombination von Imaginärteil-Filterkoeffizienten der ersten und der zweiten Harmonischen (I1, I2), wobei die Imaginärteil-Filterkoeffizienten der ersten und der zweiten Harmonischen (I1, I2) derart zur Bildung der modifizierten Koeffizienten (I1D) kombiniert werden, dass die Imaginärteil-Filterkoeffizienten der zweiten Harmonischen (I2) mit einem Faktor multipliziert und anschliessend von den Imaginärteil-Filterkoeffizienten der ersten Harmonischen (I1) subtrahiert werden,
   anschliessend entweder

   d1) Überprüfen für jeden Abtastwert ob der modifizierte Imaginärteil (I1D) das gleiche Vorzeichen wie der Imaginärteil der ersten Harmonischen (I1) hat und ob der Betrag des modifizierten Imaginärteils (I1D) grösser als der Betrag des Imaginärteils der ersten Harmonischen (I1) ist,

   e1) Setzen eines Ausgang-Imaginärteils (I1A) gleich dem modifizierten Imaginärteil (I1D) wenn die Bedingungen aus Schritt d1) erfüllt sind, oder Setzen des Ausgang-Imaginärteils (I1A) gleich dem Imaginärteil der ersten Harmonischen (I1) wenn die Bedingungen aus Schritt d1) nicht erfüllt sind,

   f1) Bestimmen einer Leitungsimpedanz (Z_L) mit Hilfe des Ausgangs-Imaginärteils (I1A),
   oder

   d2) Bestimmen einer ersten Impedanz (Z1) unter Verwendung der ersten Harmonischen (I1),

   e2) Bestimmen einer zweiten Impedanz (Z2) unter Verwendung des modifizierten Imaginärteils (I1D),

   f2) Auswahl als Leitungsimpedanz (Z_L) der betragskleineren Impedanz aus der ersten und der zweiten Impedanz (Z1, Z2) oder der Impedanz mit einem betragskleineren Imaginärteil aus der ersten und der zweiten Impedanz (Z1, Z2),
   und anschliessend

   g) Vergleichen der Leitungsimpedanz (Z_L) mit mindestens einem vorgegebenen Wert, und

   h) Ausgeben eines Steuersignals (B) für eine Unterbrechungskomponente (2) des Versorgungsnetzes falls die Leitungsimpedanz (Z_L) kleiner als der mindestens eine vorgegebene Wert ist.

2. Verfahren nach Anspruch 1, wobei der Faktor aus einem Bereich zwischen 0.5 und 2 gewählt wird, insbesondere wobei der Faktor 1.9 beträgt.

3. Verfahren nach einem der vorangehenden Ansprüche, wobei ein Leitungsstrom (i(t)) oder eine Leitungsspannung (u(t)) des Versorgungsnetzes als elektrisches zeitperiodisches Signal gemessen wird.

4. Verfahren nach einem der Ansprüche 1 bis 2, wobei zwei elektrische zeitperiodische Signale, ein Leitungsstrom (i(t)) und eine Leitungsspannung (u(t)) des Versorgungsnetzwerks gemessen werden.

5. Verfahren nach einem der vorangehenden Ansprüche, wobei das elektrische zeitperiodische Signal (i(t)) oder die elektrischen zeitperiodischen Signale (i(t), u(t)) bei einer Nennfrequenz ($f_N$) des Versorgungsnetzes ausgewertet werden.

6. Verfahren nach einem der vorangehenden Ansprüche, wobei die Überprüfung für jeden Abtastwert, ob der modifizierte Imaginärteil (I1D) das gleiche Vorzeichen wie der Imaginärteil der ersten Harmonischen (I1) hat und ob der Betrag des modifizierten Imaginärteils (I1D) grösser als der Betrag des Imaginärteils der ersten Harmonischen (I1) ist, mit einer einstellbaren Zeitverzögerung durchgeführt wird.

7. Verfahren nach Anspruch 6, wobei die einstellbare Zeitverzögerung kleiner oder gleich einer halben Periode einer Grundschwingung des elektrischen zeitperiodischen Signals (i(t)) oder der elektrischen zeitperiodischen Signale (i(t), u(t)) gewählt wird, insbesondere wobei die Zeitverzögerung 10 ms beträgt.

8. Verfahren nach einem der vorangehenden Ansprüche, wobei der Vergleich aus Schritt g) mit einem Satz oder mehreren Sätzen vorgegebener Werte durchgeführt wird.

9. Verfahren nach einem der vorangehenden Ansprüche, wobei der Schritt h) sofort nach Schritt g) oder zeitverzögert durchgeführt wird.

10. Verfahren nach einem der vorangehenden Ansprüche, wobei der Fehler (K) einer der Fehlertypen: Kurzschluss, Erdschluss, Überstrom ist.

11. Schutzvorrichtung zur Durchführung des Verfahrens zum Schutz eines elektrischen Versorgungsnetzes bei einem Fehler (K) nach einem der vorangehenden Ansprüche, umfassend
Mittel zum Messen mindestens des elektrischen zeitperiodischen Signals (i(t)) des Versorgungsnetzes,
Mittel zum Bestimmen von Realteilen und Imaginärteilen (Re{I1}, Im{I1}; Re{I2}, Im{I2}) der ersten und der zweiten Harmonischen durch Transformation des zeitperiodischen Signals (i(t)) in den Frequenzbereich,
Mittel zum Bilden der modifizierter Filterkoeffizienten mindestens für den modifizierten Imaginärteil (I1D) des transformierten zeitperiodischen Signals (i(t)) durch Kombination von Imaginärteil-Filterkoeffizienten der ersten und der zweiten Harmonischen (I1, I2),
Mittel zum Überprüfen für jeden Abtastwert ob der modifizierte Imaginärteil (I1D) das gleiche Vorzeichen wie der Imaginärteil der ersten Harmonischen (I1) hat und ob der Betrag des modifizierten Imaginärteils (I1D) grösser als der Betrag des Imaginärteils der ersten Harmonischen (I1) ist, und/oder zum Bestimmen der ersten und zweiten Impedanz (Z1, Z2) mit Hilfe der ersten Harmonischen (I1) oder mit Hilfe des modifizierten Imaginärteils (I1D),
Mittel zum Setzen des Ausgang-Imaginärteils (I1A) gleich dem modifizierten Imaginärteil (I1D) wenn die Bedingungen aus d1) erfüllt sind, oder zum Setzen des Ausgang-Imaginärteils (I1A) gleich dem Imaginärteil der ersten Harmonischen (I1) wenn die Bedingungen aus d1) nicht erfüllt sind,
Mittel zum Bestimmen der Leitungsimpedanz ($Z_L$) unter Verwendung des Ausgangs-Imaginärteils (I1A), und/oder zum Setzen der Leitungsimpedanz ($Z_L$) gleich der betragskleineren Impedanz oder gleich der Impedanz mit einem betragskleineren Imaginärteil aus der ersten und der zweiten Impedanz (Z1, Z2),
Mittel zum Vergleichen der Leitungsimpedanz ($Z_L$) mit mindestens einem vorgegebenen Wert, und zum Ausgeben des Steuersignals (B) für die Unterbrechungskomponente (2) des Versorgungsnetzes falls die Leitungsimpedanz ($Z_L$) kleiner als der mindestens eine vorgegebene Wert ist.

12. Computerprogramm das aus einem Satz von Anweisungen zur Implementierung des Verfahrens nach einem der Ansprüche 1 bis 10 besteht, insbesondere wobei das Computerprogramm mittels einer Schutzvorrichtung nach Anspruch 11 ausführbar ist.

13. Verwendung der Schutzvorrichtung nach Anspruch 11 zum Distanzschutz oder Überstromschutz von elektrischen Versorgungsnetzen.

**Claims**

1. Method for protecting an electrical supply network in case of a fault (K), comprising the steps:

   a) measuring at least an electric time-periodic signal (i(t)) of the supply network,
   b) determining real parts and imaginary parts (Re{I1}, Im{I1}; Re{I2}, Im{I2}) of the first and the second harmonic (I1, I2) by transforming the time-periodic signal (i(t)) into the frequency domain,

c) forming modified filter coefficients at least for a modified imaginary part (I1D) of the transformed time-periodic signal (i(t)) by combining imaginary part filter coefficients of the first and the second harmonic (I1, I2), wherein the imaginary part filter coefficients of the first and the second harmonic (I1, I2) are combined for forming the modified coefficients (I1D) in such a way that the imaginary part filter coefficients of the second harmonic (I2) are multiplied with a factor and subsequently are subtracted from the imaginary part filter coefficients of the first harmonic (I1),

subsequently either

d1) verifying for each sample value if the modified imaginary part (I1D) has the same algebraic sign like the imaginary part of the first harmonic (I1) and if the value of the modified imaginary part (I1D) is greater than the value of the imaginary part of the first harmonic (I1),

e1) setting an output imaginary part (I1A) such that it is equal to the modified imaginary part (I1D) if the conditions of step d1) are satisfied, or setting the output imaginary part (I1A) equal to the imaginary part of the first harmonic (I1) if the conditions of step d1) are not satisfied,

f1) determining a line impedance ($Z_L$) with the output imaginary part (I1A),

or

d2) determining a first impedance (Z1) by using the first harmonic I1),

e2) determining a second impedance (Z2) by using the modified imaginary part (I1D),

f2) choosing from the first and the second impedance (Z1, Z2) the impedance having a smaller value or from the first and the second impedance (Z1, Z2) the impedance with a smaller value of the imaginary part than line impedance ($Z_L$),

and subsequently

g) comparing the line impedance ($Z_L$) with at least a given value, and

h) issuing a control signal (B) for an interruption component (2) of the supply network if the line impedance ($Z_L$) is smaller than the at least one given value.

2. Method according to claim 1, wherein the factor is chosen from a range between 0.5 and 2, particularly wherein the factor is 1.9.

3. Method according to one of the preceding claims, wherein a line current (i(t)) or a line voltage (u(t)) of the supply network is measured as electric time-periodic signal.

4. Method according to one of the claims 1 to 2, wherein two electric time-periodic signals, a line current (i(t)) and a line voltage (u(t)), of the supply network are measured.

5. Method according to one of the preceding claims, wherein the electric time-periodic signal (i(t) or the electric time-periodic signals (i(t), u(t)) are evaluated at a nominal frequency ($f_N$) of the supply network.

6. Method according to one of the preceding claims, wherein the verification for each sample value if the modified imaginary part (I1D) has the same algebraic sign like the imaginary part of the first harmonic (I1) and if the value of the modified imaginary part (I1D) is greater than the value of the imaginary part of the first harmonic (I1) is carried out with an adjustable delay.

7. Method according to claim 6, wherein the adjustable delay is chosen to be smaller than or equal to a half of a period of a fundamental oscillation of the electric time-periodic signal (i(t)) or of the electric time-periodic signals (i(t), u(t)), particularly wherein the delay is 10 ms.

8. Method according to one of the preceding claims, wherein the comparison of step g) is carried out with a set or multiple sets of given values.

9. Method according to one of the preceding claims, wherein the step h) is carried out immediately after step g) or with a delay.

10. Method according to one of the preceding claims, wherein the fault (K) is one of the fault types: short circuit, earth fault, overcurrent.

11. Protection device for carrying out the method for protecting an electrical supply network in case of a fault (K) according to one of the preceding claims, comprising

means for measuring at least the electric time-periodic signal (i(t)) of the supply network,

means for determining real parts and imaginary parts (Re{I1}, Im{I1}; Re{I2}, Im{I2}) of the first and the second harmonic by transforming the time-periodic signal (i(t)) into the frequency domain,

means for forming the modified filter coefficients at least for the modified imaginary part (I1D) of the transformed time-periodic signal (i(t)) by combining imaginary part filter coefficients of the first and the second harmonic (I1, I2),

means for verifying for each sample value if the modified imaginary part (I1D) has the same algebraic sign like the imaginary part of the first harmonic (I1) and if the value of the modified imaginary part (I1D) is greater than the value of the imaginary part of the first harmonic (I1), and/or for determining the first and the second impedance (Z1, Z2) with the first harmonic (I1) or with the modified imaginary part (I1D),

means for setting the output imaginary part (I1A) such that it is equal to the modified imaginary part (I1D) if the conditions of step d1) are satisfied, or for setting the output imaginary part (I1A) equal to the imaginary part of the first harmonic (I1) if the conditions of step d1) are not satisfied,

means for determining the line impedance ($Z_L$) by using the output imaginary part (I1A), and/or for setting the line impedance ($Z_L$) such that it is equal to that impedance with a smaller value or equal to that impedance with a smaller value of the imaginary part from the first and the second impedance (Z1, Z2),

means for comparing the line impedance ($Z_L$) with at least a given value and for issuing a control signal (B) for the interruption component (2) of the supply network if the line impedance ($Z_L$) is smaller than the at least one given value.

12. Computer program, consisting of a set of instructions for implementing the method according to one of the claims 1 to 10, particularly wherein the computer program is executable by means of a protection device according to claim 11.

13. Use of the protection device according to claim 11 for distance protection or overcurrent protection of electrical supply grids.

**Revendications**

1. Procédé de protection d'un réseau d'alimentation électrique en cas d'un défaut (K), comprenant les étapes:

a) de mesurer au moins un signal temporel périodique (i(t)) du réseau d'alimentation,
b) de déterminer des parties réelles et imaginaires (Re{I1}, Im{I1}; Re{I2}, Im{I2}) de la première et la deuxième harmonique (I1, I2) en transformant le signal temporel périodique (i(t)) dans le domaine des fréquences,
c) de former des coefficients de filtre modifiés au moins pour une partie imaginaire modifiée (I1D) du signal temporel périodique (i(t)) transformé en combinant des coefficients de filtre de la partie imaginaire de la première et la deuxième harmonique (I1, I2), les coefficients de filtre de la partie imaginaire de la première et la deuxième harmonique (I1, I2) étant combinés pour former les coefficients modifiés (I1D) de sorte que les coefficients de filtre de la partie imaginaire de la deuxième harmonique (I2) sont multipliés avec un facteur et ensuite sont soustraits des coefficients de filtre de la partie imaginaire de la première harmonique (I1),
ensuite soit
d1) de vérifier pour chaque valeur d'échantillon si la partie imaginaire modifiée (I1D) a le même signe algébrique que la partie imaginaire de la première harmonique (I1) et si la valeur de la partie imaginaire modifiée (I1D) est supérieure à la valeur de la première harmonique (I1),
e1) établir une partie imaginaire de sortie (I1A) de sorte qu'elle est égale à la partie imaginaire modifiée (I1D) si les conditions de l'étape d1) sont satisfaites, ou établir la partie imaginaire de sortie (I1A) égale à la partie imaginaire de la première harmonique (I1) si les conditions de l'étape d1) ne sont pas satisfaites,
f1) de déterminer une impédance de ligne ($Z_L$) avec la partie imaginaire de sortie (I1A),
ou
d2) de déterminer une première impédance (Z1) en utilisant la première harmonique (I1),
e2) de déterminer une deuxième impédance (Z2) en utilisant la partie imaginaire modifiée (I1D),
f2) de choisir à partir de la première et la deuxième impédance (Z1, Z2) l'impédance ayant une valeur inférieure et à partir de la première et la deuxième impédance (Z1, Z2) l'impédance avec une valeur de la partie imaginaire inférieure à l'impédance de ligne ($Z_L$),
et ensuite
g) de comparer l'impédance de ligne ($Z_L$) avec au moins une valeur donnée, et
h) d'emmètre un signal de commande (B) pour un composant d'interruption électrique (2) du réseau d'alimentation si l'impédance de ligne ($Z_L$) est inférieure par rapport à l'au moins une valeur donnée.

2. Procédé selon la revendication 1, le facteur étant choisi d'une gamme comprise entre 0.5 et 2, particulièrement le facteur étant 1.9.

3. Procédé selon l'une des revendications précédentes, un courant de ligne (i(t)) ou une tension de ligne (u(t)) du réseau d'alimentation étant mesuré comme signal temporel périodique électrique.

4. Procédé selon l'une des revendications 1 à 2, deux signaux temporels périodiques électriques, un courant de ligne (i(t)) et une tension de ligne (u(t)), du réseau d'alimentation étant mesurés.

5. Procédé selon l'une des revendications précédentes, le signal temporel périodique électrique (i(t)) ou les signaux temporels périodiques électriques (i(t), u(t)) étant évalué(s) à une fréquence nominale ($f_N$) du réseau d'alimentation.

**6.** Procédé selon l'une des revendications précédentes, la vérification pour chaque valeur d'échantillon si la partie imaginaire modifiée (I1D) a le même signe algébrique que la partie imaginaire de la première harmonique (I1) et si la valeur de la partie imaginaire modifiée (I1D) est supérieure à la valeur de la partie imaginaire de la première harmonique (I1) étant effectuée avec un délai ajustable.

**7.** Procédé selon la revendication 6, le délai ajustable étant choisi à être inférieur que ou égale à une moitié d'une période d'une oscillation fondamentale du signal temporel périodique électrique (i(t)) ou des signaux temporels périodiques électriques (i(t), u(t)), particulièrement le délai étant de 10 ms.

**8.** Procédé selon l'une des revendications précédentes, la comparaison de l'étape g) étant effectuée avec un set ou des multiples sets de valeurs données.

**9.** Procédé selon l'une des revendications précédentes, l'étape h) étant effectuée immédiatement après l'étape g) ou avec un délai.

**10.** Procédé selon l'une des revendications précédentes, le défaut (K) étant un des types de défaut: court-circuit, défaut à la terre, surintensité.

**11.** Dispositif de protection pour effectuer le procédé de protection d'un réseau d'alimentation électrique en cas d'un défaut (K) selon l'une des revendications précédentes, comprenant:

des moyens de mesurer au moins un signal temporel périodique (i(t)) du réseau d'alimentation, des moyens de déterminer des parties réelles et imaginaires (Re{I1}, Im{I1}; Re{I2}, Im{I2}) de la première et la deuxième harmonique (I1, I2) en transformant le signal temporel périodique (i(t)) dans le domaine des fréquences, des moyens de former les coefficients de filtre modifiés au moins pour la partie imaginaire modifiée (I1D) du signal temporel périodique (i(t)) transformé en combinant des coefficients de filtre de la partie imaginaire de la première et la deuxième harmonique (I1, I2), des moyens de vérifier pour chaque valeur d'échantillon si la partie imaginaire modifiée (I1D) a le même signe algébrique que la partie imaginaire de la première harmonique (I1) et si la valeur de la partie imaginaire modifiée (I1D) est supérieure à la valeur de la première harmonique (I1), et/ou de déterminer la première et la deuxième impédance (Z1, Z2), avec la première harmonique (I1) ou avec la partie imaginaire modifiée (I1D), des moyens d'établir la partie imaginaire de sortie (I1A) de sorte qu'elle est égale à la partie imaginaire modifiée (I1D) si les conditions de l'étape d1) sont satisfaites, ou d'établir la partie imaginaire de sortie (I1A) égale à la partie imaginaire de la première harmonique (I1) si les conditions de l'étape d1) ne sont pas satisfaites, des moyens de déterminer l'impédance de ligne $(Z_L)$ en utilisant la partie imaginaire de sortie (I1A), et/ou d'établir l'impédance de ligne $(Z_L)$ de sorte qu'elle est égale à l'impédance avec une valeur inférieure ou égale à l'impédance telle qu'elle a une valeur inférieure de la partie imaginaire parmi la première et la deuxième impédance (Z1, Z2), des moyens de comparer l'impédance de ligne $(Z_L)$ avec au moins une valeur donnée, et d'emmètre un signal de commande (B) pour un composant d'interruption électrique (2) du réseau d'alimentation si l'impédance de ligne $(Z_L)$ est inférieure par rapport à l'au moins une valeur donnée.

**12.** Logiciel d'ordinateur, consistant d'un set d'instructions pour implémenter le procédé selon l'une des revendications 1 à 10, particulièrement le logiciel d'ordinateur étant exécutable à l'aide d'un dispositif de protection selon la revendication 11.

**13.** Utilisation du dispositif de protection selon la revendication 11 pour la protection à distance ou la protection contre surintensité des réseaux d'alimentation électriques.

Fig. 1

Fig. 2

$$\underline{Z}=R+jX$$

Fig. 3

Fig. 4

Fig. 5

Fig. 6

Fig. 7